# FASCICULE DE BREVET EUROPEEN

(11) **EP 2 596 536 B1**
(45) Date de publication et mention de la délivrance du brevet: **30.09.2015**
(21) Numéro de dépôt: 11735481.1
(22) Date de dépôt: 10.06.2011
(51) Int. Cl.: H01L 51/48

(54) **PROCEDE POUR LA FABRICATION D'UNE COUCHE SEMI-CONDUCTRICE ORGANIQUE CONSTITUEE D'UN MELANGE D'UN PREMIER ET D'UN SECOND MATERIAUX SEMI-CONDUCTEURS**
VERFAHREN ZUR HERSTELLUNG EINER ORGANISCHEN HALBLEITERSCHICHT AUS EINER MISCHUNG AUS EINEM ERSTEN UND ZWEITEN HALBLEITER
PROCESS FOR PRODUCING AN ORGANIC SEMICONDUCTOR LAYER CONSISTING OF A MIXTURE OF A FIRST AND A SECOND SEMICONDUCTOR

(30) Priorité: 22.07.2010 FR 1055990
(43) Date de publication de la demande: 29.05.2013
(73) Titulaire: Commissariat à l'Énergie Atomique et aux Énergies Alternatives, 75015 Paris (FR)
(72) Inventeur: BENWADIH, Mohammed, F-94500 Champigny/marne (FR)
(74) Mandataire: Vuillermoz, Bruno
(86) Numéro de dépôt international: PCT/FR2011/051332
(87) Numéro de publication internationale: WO 2012/010759

(56) Documents cités:
- DE-A1-102007 000 791
- US-A1- 2005 098 204
- US-A1- 2009 050 206
- US-A1- 2009 194 167

## Description

### DOMAINE DE L'INVENTION

L'invention concerne la fabrication de couches semi-conductrices organiques constituées d'un mélange d'un premier et d'un second matériaux semi-conducteurs, plus particulièrement de couches semi-conductrices organiques entrant dans la constitution de dispositifs optoélectroniques organiques, notamment des photodiodes.

### ETAT DE LA TECHNIQUE

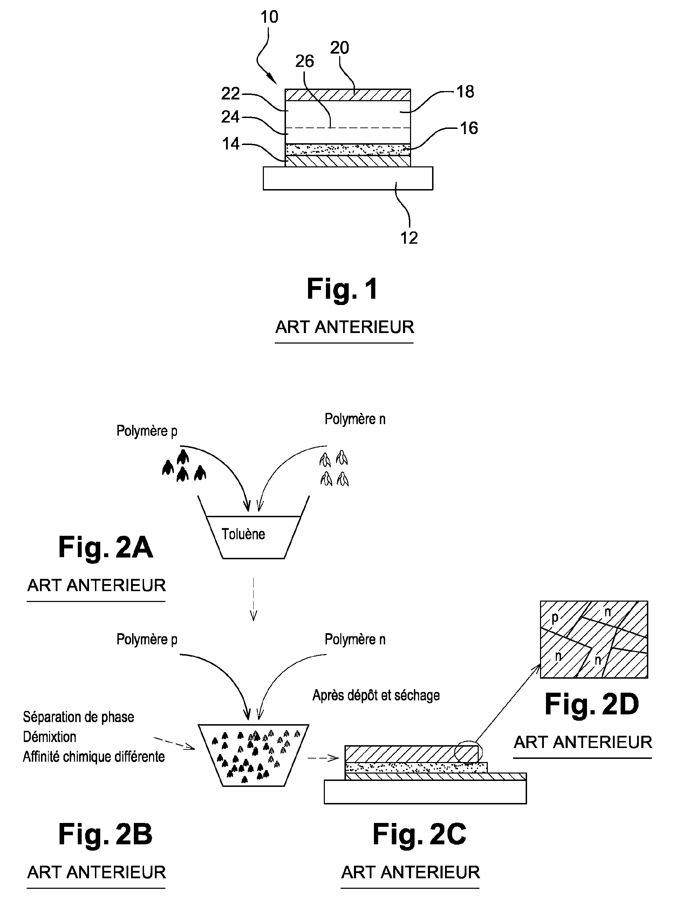

En se référant à la figure 1, qui est une vue en coupe schématique d'une photodiode organique **10** de l'art antérieur, une telle photodiode comprend usuellement un empilement constitué, du bas vers le haut :
▪ d'un substrat **12** transparent, par exemple constitué d'un verre ;
▪ d'une couche **14** formant première électrode, par exemple constituée d'un oxyde d'indium-étain, usuellement désigné sous l'acronyme « ITO » pour *«Indium Tin Oxyde » ;*
▪ d'une couche d'injection **16**, par exemple constituée d'un mélange de poly(3,4-éthylènedioxythiophène), usuellement désigné sous l'acronyme « PEDOT », et de polystyrène sulfonate de sodium, usuellement désigné sous l'acronyme « PSS », ce mélange étant lui-même usuellement désigné sous l'acronyme « PEDOT:PSS ». La couche d'injection **16** facilite le passage des trous depuis la première électrode **14** vers la couche semi-conductrice active **18** ;
▪ une couche semi-conductrice active **18** formant jonction PN, constituée d'un mélange de deux matériaux semi-conducteurs organiques P et N, usuellement un mélange de deux polymères, par exemple un mélange de poly(3-hexylthiophène), usuellement désigné sous l'acronyme « P3HT, et de [6,6]-phényl-C61-butyrate de méthyle, usuellement désigné sous l'acronyme « PCBM » ; et
▪ une couche **20** formant seconde électrode, par exemple constituée de calcium, d'argent ou d'aluminium, le calcium étant préféré en raison de son faible travail de sortie qui permet de collecter uniquement des électrons.

En fonctionnement, un rayonnement électromagnétique illumine le substrat **12** et les photons qui atteignent la couche active **18** créent des paires électron-trou. En soumettant les électrodes **14** et **20** à une différence de potentiel, un courant est alors collecté dont la valeur est fonction de l'illumination de la photodiode **10**.

Le rendement d'une telle photodiode **10** dépend toutefois de la surface de contact existant dans la couche active **18** entre le matériau semi-conducteur organique de type P, par exemple le P3HT, et le matériau semi-conducteur organique de type N, par exemple le PCBM, le rendement se dégradant rapidement à mesure que la surface de contact diminue. De plus, le rendement dépend aussi de la taille des domaines, ces derniers devant être peu étendus de façon à ce que les charges puissent les traverser pour atteindre l'électrode sans être recombinées. A cet égard, une couche active **18** idéale est ainsi constituée d'un mélange homogène à l'échelle moléculaire des deux matériaux semi-conducteurs organiques.

Il n'est cependant pas possible d'obtenir une telle homogénéité avec les techniques actuelles de dépôt. En effet, la couche active **18** est usuellement réalisée en déposant une solution comportant un solvant dans lequel sont dissouts ou dispersés les matériaux semi-conducteurs organiques, puis en procédant à l'évaporation du solvant.

Lorsque la vitesse d'évaporation du solvant est trop faible, on observe alors une séparation de phases, la couche **18** étant finalement constituée d'une couche **22** de premier matériau semi-conducteur et d'une couche **24** de second matériau semi-conducteur. La surface de contact **26** entre les deux matériaux est alors très faible, et donc le rendement de la photodiode **10** est altéré.

Comme illustré aux figures 2A-2D, ce problème se pose également en choisissant un solvant extrêmement volatile, comme le toluène par exemple. Ainsi en mélangeant les deux matériaux semi-conducteurs dans le toluène de manière à former un mélange initialement le plus homogène possible, par exemple par agitation magnétique (fig. 2A), la solution obtenue est très instable. Des séparations de phase locales (figure 2B), d'origine thermodynamique et dues aux phénomènes physicochimiques d'attraction et de répulsion des molécules entre elles, apparaissent rapidement avant même que la solution soit déposée sur la première électrode **14** (figure 2C). Ce phénomène se poursuit pendant l'évaporation du solvant volatile et on observe au final dans la couche **18** de larges zones formées uniquement d'un seul type de matériau (figure 2D).

Ainsi, on observe usuellement que 80% des zones ont au moins une dimension supérieure à 10 µm. La surface totale de contact entre les deux matériaux semi-conducteurs organiques est donc là encore réduite, et le rendement de la photodiode est faible.

Le document US-A-2009/050206 décrit un procédé de fabrication d'une couche organique semi-conductrice comportant un volume poreux en un premier matériau semi-conducteur dont les pores sont remplis d'un second matériau semi-conducteur. Le volume poreux est fabriqué en utilisant une séparation de phase de deux matériaux mélangés en solution, puis après solidification de la solution, le second matériau est retiré pour libérer les pores latéraux. Tout d'abord avec un tel procédé de fabrication du volume poreux, il est difficile de régler avec précision la géométrie des pores, notamment leurs dimensions, mais en outre, il reste des résidus du second matériau qui nuit à la qualité de la couche semi-conductrice organique.

### EXPOSE DE L'INVENTION

Le but de la présente invention est de résoudre le problème susmentionné en proposant un procédé de fabrication d'une couche semi-conductrice organique constituée de deux matériaux semi-conducteurs organiques ayant une surface de contact entre ces matériaux élevée, à savoir un volume poreux réalisé en un premier matériau semi-conducteur dont les pores sont imprégnés, au moins partiellement, d'un second matériau semi-conducteur, qui permet un réglage accru de la géométrie des pores et permet l'obtention d'un volume poreux sans résidu propre à nuire à la qualité de la couche semi-conductrice organique.

A cet effet, le procédé de fabrication d'une telle couche comporte :
▪ la réalisation d'un volume solide poreux constitué du premier matériau semi-conducteur, de porosité ouverte et adaptée pour recevoir un second matériau semi-conducteur ;
▪ le dépôt, au moins sur une surface externe du volume solide poreux, d'un liquide comportant le second matériau semi-conducteur dissout ou dispersé dans un solvant, le solvant étant inerte vis-à-vis du premier matériau semi-conducteur et de température d'évaporation inférieure à la température d'évaporation du second matériau semi-conducteur ; et
▪ une fois le volume solide poreux au moins partiellement imbibé par le liquide, l'évaporation du solvant par chauffage à une température supérieure à la température d'évaporation dudit solvant et inférieure à la température d'évaporation du premier et du second matériau semi-conducteur.

La réalisation du solide poreux comporte l'introduction de bulles de gaz dans une solution de premier matériau semi-conducteur dissout ou dispersé dans un solvant, puis l'évaporation dudit solvant, la température du solvant étant inférieure à la température d'évaporation du gaz.

Par matériau poreux à « porosité ouverte », il doit être entendu ici un matériau dont les pores communiquent les uns avec les autres de manière à créer un espace interne au matériau qui soit accessible depuis l'extérieur de celui-ci, et donc « remplissable ».

En d'autres termes, préalablement à la mise en contact des deux matériaux organiques, une grande surface de contact stable est créée. Cette surface est alors indifférente à la non affinité physicochimique des deux matériaux semi-conducteurs et il est obtenu une couche semi-conductrice présentant une homogénéité élevée ainsi qu'une meilleure adhésion entre les deux matériaux semi-conducteurs. Par exemple, on observe une augmentation élevé du rendement d'une photodiode organique d'un facteur compris entre 5 et 100.

Ensuite, la fabrication du volume solide poreux permet, d'une part, d'obtenir une grande diversité dans la taille et la densité des pores, et d'autre part, de réaliser des matériaux « propres » sans résidu.

En effet, l'utilisation d'un gaz permet d'obtenir des bulles plus petites que les gouttes que l'on peut obtenir par une émulsion d'un ou plusieurs matériau dans un solvant, ce qui permet donc d'avoir une porosité très fine, et donc une haute densité de pores répartis de façon homogène dans tout le volume du premier matériau constitutif du volume poreux. De plus, selon le gaz choisi, les bulles de gaz seront plus ou moins grosses, et de là, la taille des pores peut être ajustée avec une précision accrue.

Par ailleurs, l'évaporation du gaz ne laisse aucun résidu dans le volume solide poreux final.

Selon un mode de réalisation de l'invention, le premier matériau semi-conducteur est du P3HT et le second matériau semi-conducteur est du PCBM.

### BREVE DESCRIPTION DES FIGURES

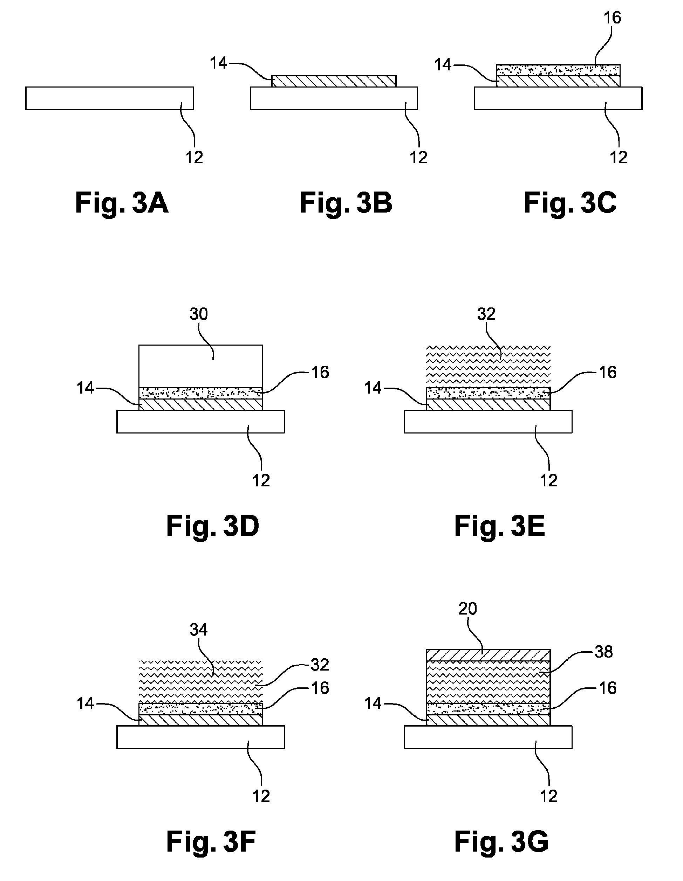

L'invention sera mieux comprise à la lecture de la description qui va suivre, donnée uniquement à titre d'exemple, et réalisée en relation avec les dessins annexés, dans lesquels des références identiques désignent des éléments identiques ou analogues, et dans lesquels :
▪ la figure 1 est une vue schématique en coupe d'une photodiode organique de l'état de la technique ;
▪ les figures 2A à 2D illustrent un procédé de l'état de la technique de dépôt d'une solution de deux matériaux semi-conducteurs organiques dans un solvant volatil pour former la couche active de la photodiode organique de l'état de la technique ; et
▪ les figures 3A à 3G sont des vues schématiques en coupe de différentes étapes du procédé de fabrication d'une photodiode organique selon l'invention.

### DESCRIPTION DETAILLEE DE L'INVENTION

En se référant aux figures 3A à 3G, un procédé de fabrication d'une photodiode organique selon l'invention débute classiquement par la réalisation d'un substrat en verre **12** (figure 3A), suivie de la réalisation d'une métallisation **14** en ITO par gravure sur le substrat **12** afin de former la première électrode de la photodiode (figure 3B). Le procédé se poursuit alors classiquement par le dépôt d'une couche d'injection **16** en PEDOT:PPS sur la première électrode **14** (figure 3C).

Le procédé se poursuit par la fabrication d'une couche poreuse en P3HT. Plus particulièrement, du P3HT est dissout ou dispersé dans un premier solvant « B », tel qu'un alcane par exemple. La solution ainsi obtenue est mélangée à un second solvant « C » non miscible au premier solvant « B », ayant une température d'évaporation inférieure à celle du premier solvant « B ». Par exemple, le second solvant est du chlorobenzène ou du chloroforme. Le mélange ainsi obtenu est émulsifié par exemple par agitation mécanique et l'émulsion **30** est déposée sur la couche d'injection **16** (figure 3D).

Le second solvant « C » est alors évaporé, par exemple par chauffage à une température supérieure ou égale à la température d'évaporation de celui-ci mais inférieure à la température d'évaporation du premier solvant « B ». Ensuite, le premier solvant « B » est évaporé, par exemple par chauffage à une température supérieure à la température d'évaporation de celui-ci.

Une couche poreuse solide **32** en P3HT, ayant une porosité ouverte pouvant recevoir une solution de PCBM, est ainsi obtenue (figure 3E). Cette couche **32** présente des pores de diamètre 100 nm à raison de 10 pores/µm (linéaire) sur une surface totale de 500 µm².

Les propriétés de l'émulsion, et notamment la taille des gouttelettes de P3HT dans le premier solvant B et la concentration de celles-ci dans le second solvant C, règlent la porosité finale de la couche poreuse **32**. Il est ainsi possible de réaliser une couche **32** avec des macropores, dont la largeur est supérieure à 50 nanomètres, des mésopores, dont la largeur est comprise entre 2 nanomètres et 50 nanomètres, ou des micropores, dont la largeur est inférieure à 2 nanomètres. La taille des pores est réglée par la nature des solvants, par la hauteur de leur non-miscibilité et par leur vitesse d'évaporation.

De manière avantageuse, un additif peut également être ajouté à l'émulsion venant d'être décrite afin de la stabiliser, notamment dans le cas d'une forte concentration de gouttelettes. Par exemple, l'additif est un agent tensio-actif, un émulsifiant, comme par exemple des macromolécules biologiques, de fines particules, par exemple de savon, ou des polymères, par exemple des polymères aminés hydrophiles comme l'amino-trimethoxysilane.

En outre, les émulsifiants présentent l'avantage de réduire la tension interfaciale entre les deux solvants à quelques millinewtons par mètre, voire quelques micronewtons par mètre, lorsqu'ils sont en présence d'un agent tensioactif, ce qui permet de diminuer l'énergie nécessaire pour accroître l'aire interfaciale. Ceci préserve la petite taille des domaines, la porosité s'en trouvant donc augmentée.

Le procédé se poursuit alors par le dépôt d'une solution de PCBM **34** dans un troisième solvant « A », par exemple du cyclohexane, sur la face libre de la couche poreuse **32**. La solution imbibe alors complètement la couche poreuse **32** (figure 3F).

Le troisième solvant « A » utilisé pour dissoudre ou disperser le PCBM est choisi pour présenter une température d'évaporation inférieure à celle du PCBM, et avantageusement pour être volatil. Ce solvant est également choisi pour être inerte vis-à-vis du matériau constitutif de la couche poreuse **32**, dans l'exemple du P3HT, afin de ne pas redissoudre ce matériau.

Un chauffage de la couche poreuse **32** imbibée par la solution de PCBM est alors réalisé à une température supérieure ou égale à la température d'évaporation du troisième solvant, mais inférieure à la température d'évaporation du PCBM. Une couche semi-conductrice organique **38** constituée d'un mélange de P3HT et PCBM à haut degré d'homogénéité est ainsi obtenue (figure 3G).

Le procédé se termine alors par le dépôt sur la face libre de la couche **38** d'une couche **20** formant la seconde électrode, par exemple une couche de calcium, d'aluminium ou d'argent (figure 3G).

Dans ce qui précède la couche poreuse est obtenue par émulsion.

En variante, la couche poreuse est obtenue par polymérisation de polystyrène. Un polystyrène poreux, dont la porosité est obtenue directement lors de sa polymérisation, est utilisé. Les pores du polystyrène sont remplis tout d'abord par le premier matériau puis par le second matériau. Le polystyrène reste alors un squelette inactif.

Selon l'invention, la couche poreuse est obtenue par ajout de gaz, c'est-à-dire par formation d'une mousse. Des bulles de gaz sont introduites dans une solution comprenant le premier matériau. Lors de l'évaporation du solvant, les bulles restent alors emprisonnées si la température d'évaporation du solvant est inférieure à la température d'évaporation du gaz. Le solvant s'évapore donc avec la libération du gaz. Ce dernier peut être introduit artificiellement (air, CO₂...) ou bien il peut être créé in situ par la réaction de polymérisation du premier matériau qui crée des résidus (CO₂...) par exemple la polymérisation du polyuréthane ou de résine epoxy.

La taille des bulles de gaz et la nature du gaz permet de régler avec précision la géométrie des pores, taille et densité notamment.

De même, il a été décrit un mode de réalisation dans lequel une couche poreuse en P3HT est remplie de PCBM. En variante, une couche poreuse en PCBM est remplie de P3HT.

De même, il a été décrit un mode de réalisation dans lequel du P3HT et du PCBM sont utilisés. Bien entendu, d'autres types de matériaux semi-conducteurs organiques, de type polymères ou non, peuvent être utilisés en fonction de l'application visée. Le choix des premier et second solvants utilisés pour la réalisation de l'émulsion qui donne la couche organique active après leur élimination, dépend évidemment du choix des matériaux semi-conducteurs organiques. On retiendra simplement que les solvants sont choisis non miscibles, ou très peu miscibles entre eux, et que la température d'évaporation du second solvant est inférieure à la température d'évaporation du premier solvant.

De même, il a été décrit un mode de réalisation dans lequel une photodiode organique est fabriquée. Bien entendu, la couche semi-conductrice organique constituée du mélange des matériaux semi-conducteurs obtenue par le procédé de fabrication selon l'invention peut être utilisée dans d'autres types de composants microélectroniques organiques, comme par exemple un transistor ambipolaire.

## Revendications

1. Procédé pour la fabrication d'une couche semi-conductrice organique (38) constituée d'un mélange d'un premier et d'un second matériaux semi-conducteurs organiques, le procédé comprenant :
▪ la réalisation d'un volume solide poreux (32) constitué du premier matériau semi-conducteur, de porosité ouverte et adaptée pour recevoir un second matériau semi-conducteur ;
▪ le dépôt, au moins sur une surface externe du volume solide poreux, d'un liquide (34) comportant le second matériau semi-conducteur dissout ou dispersé dans un solvant (A), le solvant (A) étant inerte vis-à-vis du premier matériau semi-conducteur et de température d'évaporation inférieure à la température d'évaporation du second matériau semi-conducteur ; et
▪ une fois le volume solide poreux (32) au moins partiellement imbibé par le liquide, l'évaporation du solvant (A) par chauffage à une température supérieure à la température d'évaporation dudit solvant et inférieure à la température d'évaporation du premier et du second matériaux semi-conducteurs.
***caractérisé* en ce que** la réalisation du solide poreux comporte l'introduction de bulles de gaz dans une solution de premier matériau semi-conducteur dissout ou dispersé dans un solvant (B'), puis l'évaporation dudit solvant (B'), la température dudit solvant (B') étant inférieure à la température d'évaporation du gaz.

2. Procédé selon la revendication 1, ***caractérisé* en ce que** le premier matériau semi-conducteur est du P3HT et le second matériau semi-conducteur est du PCBM.

## Patentansprüche

1. Verfahren zur Fertigung einer organischen Halbleiterschicht (38), die aus einem Gemisch aus einem ersten und zweiten organischen Halbleitermaterial besteht, wobei das Verfahren umfasst:
▪ Herstellen eines aus dem ersten Halbleitermaterial bestehenden porösen Festkörpervolumens (32) mit offener Porosität, die dazu angepasst ist, ein zweites Halbleitermaterial aufzunehmen;
▪ Aufbringen einer das in einem Lösungsmittel (A) aufgelöste oder dispergierte zweite Halbleitermaterial umfassenden Flüssigkeit (34) auf mindestens eine Außenfläche des porösen Festkörpervolumens, wobei das Lösungsmittel (A) gegenüber dem ersten Halbleitermaterial inert ist und eine Verdampfungstemperatur hat, die niedriger ist als die Verdampfungstemperatur des zweiten Halbleitermaterials; und
▪ sobald das poröse Festkörpervolumen (32) zumindest teilweise mit der Flüssigkeit getränkt ist, Verdampfen des Lösungsmittels (A) durch Erwärmen auf eine Temperatur, die höher ist als die Verdampfungstemperatur des Lösungsmittels und niedriger als die Verdampfungstemperatur des ersten und zweiten Halbleitermaterials,
**dadurch gekennzeichnet, dass** die Herstellung des porösen Festkörpers das Einbringen von Gasblasen in eine Lösung des in einem Lösungsmittel (B') aufgelösten oder dispergierten ersten Halbleitermaterials umfasst, dann die Verdampfung des Lösungsmittels (B'), wobei die Temperatur des Lösungsmittels (B') niedriger ist als die Verdampfungstemperatur des Gases.

2. Verfahren nach Anspruch 1, **dadurch gekennzeichnet, dass** das erste Halbleitermaterial P3HT und das zweite Halbleitermaterial PCBM ist.

## Claims

1. A method for manufacturing an organic semiconductor layer (38) formed of a mixture of a first and of a second organic semiconductor materials, the method comprising:
▪ forming a porous solid volume (32) formed of the first semiconductor material, of intercommunicating porosity and capable of receiving a second semiconductor material;
▪ depositing, at least on an external surface of the porous solid volume, a liquid (34) comprising the second semiconductor material dissolved or dispersed in a solvent (A), the solvent (A) being inert with respect to the first semiconductor material and having an evaporation temperature lower than the evaporation temperature of the second semiconductor material; and
▪ once the porous solid volume (32) has been at least partially impregnated with the liquid, evaporating the solvent (A) by heating up to a temperature higher than the evaporation temperature of said solvent and lower than the evaporation temperature of the first and of the second semiconductor materials,
**characterized in that** the forming of the porous solid comprises introducing gas bubbles into a solution of first semiconductor material dissolved or dispersed in a solvent (B'), followed by the evaporating of said solvent (B'), the temperature of said solvent (B') being lower than the gas evaporation temperature.

2. The method of claim 1, **characterized in that** the first semiconductor material is P3HT and the second semiconductor material is PCBM.
